# EUROPEAN PATENT APPLICATION

(11) **EP 0 779 658 A2**
(43) Date of publication of application: **18.06.1997**
(21) Application number: 96309134.3
(22) Date of filing: 13.12.1996
(51) Int. Cl.: H01L 23/367

(54) **A heat sink arrangement**

(30) Priority: 14.12.1995 US 8640
(71) Applicant: TEXAS INSTRUMENTS INCORPORATED, Dallas Texas 75265 (US)
(72) Inventor: Edwards, Darwin R, Garland, TX 75044 (US)
(74) Representative: Blanco White, Henry Nicholas

(57) **Abstract**

The invention is to a heat sink and heat spreader (20)for mounting on a surface of a semiconductor device package. A heat sink plate (24)has first (21a) and second surfaces (21b) wherein the first surface (21a) serves as a thermal dissipation surface. An adhesive (24)is applied to the second surface (21b) of said heat sink plate (21) for adhering the heat sink to the surface of a semiconductor device package.

## Description

### FIELD OF THE INVENTION

This invention relates to semiconductor devices and heat dissipation thereof, and more particularly to a heat sink arrangement comprising a combination heat sink and heat spreader device that is taped or adhered to the top of a semiconductor device.

### BACKGROUND OF THE INVENTION

Traditional methods of heat dissipation for semiconductor devices and integrated circuits include the use of pin fin or stacked plate heat dissipators on the package backside. The performance of these dissipators depends on the surface area and the thermal 1 conductivity of the device and the heat dissipators as well as the ambient temperature and air flow rate around the device.

Prior devices have also used a heat spreader molded into the semiconductor package. The semiconductor chip has been mounted on the heat spreader in one embodiment, and the heat spreader placed upon the chip in another embodiment. In both examples, the heat spreader is molded into the package.

### SUMMARY OF THE INVENTION

The invention relates to a heat sink and heat spreader arrangement for mounting on a surface of a semiconductor device package. A heat sink plate has first and second surfaces wherein the first surface serves as a thermal dissipation surface. An adhesive is applied to the second surface of said heat sink plate for adhering the heat sink to the surface of a semiconductor device package, and for thermal conduction to the surface.

### BRIEF DESCRIPTION OF THE DRAWINGS

The technical advance represented by the invention as well as the objects thereof will become apparent from the following description of a preferred embodiment of the invention when considered in conjunction with the accompanying drawings in which:-
Figure 1 is a side view of a semiconductor device with an attached heat sink in accordance with the present invention;
Figure 2 shows an alternative embodiment of the invention in which the attached heat sink has raised heat dissipation fins;
Figure 3 shows a further embodiment of the invention with the heat sink extending down the side of the semiconductor device;
Figure 4 is an isometric view of the heat sink of Figure 2 shown on the semiconductor device;
Figure 5 shows another embodiment of the heat sink of the invention having heat dissipation fins;
Figure 6 is a table comparing devices with and without the heat sink of the present invention; and
Figure 7 is a graph showing heat dissipation improvement with and with out the heat sink of the present invention dependent upon the size of the semiconductor die in the semiconductor package upon which the heat sink is mounted.

### DESCRIPTION OF A PREFERRED EMBODIMENT

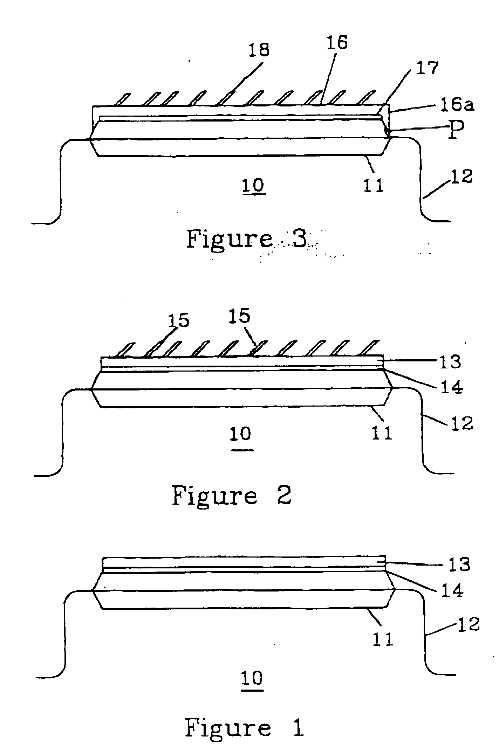

Figure 1 is a side view of a heat sink/semiconductor device assembly 10 which includes semiconductor device 11, having leads 12, with an attached heat sink 13. Heat sink 13, punched from a thin metal plate, is attached to the top of semiconductor 11 with an adhesive or adhesive tape 14. In practice, semiconductor device 11 may be attached to a printed circuit board (not illustrated). If a heat sink is thereafter required, then heat sink 13 may be attached to the top of semiconductor 11.

Heat sink 13 may be formed or punched from a plate of metal, for example copper or aluminum, or other good heat dissipating material and taped, glued or otherwise adhered to the plastic or ceramic semiconductor package surface. Heat sink 13, being applied to the semiconductor package allows the semiconductor device to be thinner than possible with a heat spreader encapsulated in the package.

Heat sink 13 may be stamped to provide heat dissipation fins as illustrated in Figure 2. In Figure 2, heat sink 14 has a plurality of heat dissipation fins 15 which are stamped in the surface of heat sink 13. In stamping, each fin is cut along three sides to allow the fin to be flexed or bent upward.

Figure 3 shows a variation in the heat sink. Heat sink 16 has edges 16a extending downward along the edges of semiconductor device 11. This provides a greater heat dissipation surface and provides a shorter thermal path, through device 11, from the edges 16a to the leads 12. This provides greater heat dissipation. The dissipation path is shown by arrow P.

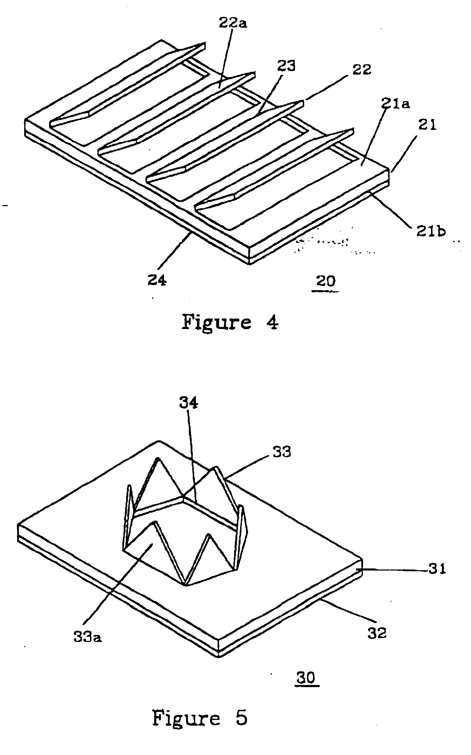

Figure 4 is an isometric illustration of a stamped heat sink 20 with dissipation fins 22. Each fin 22 is cut from the metal plate of heat sink 21 along three edges, leaving fin 22 connected to heat sink plate 21 at edge 23. The fins 22 extend from a first surface 21a. Heat dissipation fin 22 may then be bent or flexed upward at edge 23 to move fin 22 out of the plane of heat sink plate 21, allowing better air flow around fin 22, hence providing better heat dissipation. Plate 21 has a layer 24, on second surface 21b, of an adhesive to adhere heat sink plate 21 to a semiconductor device package. Each fin 22 may have a high thermal emissivity surface finish 22a. This coating may be deposited, painted or otherwise placed on the heat sink surface. In one embodiment, the surface was painted black.

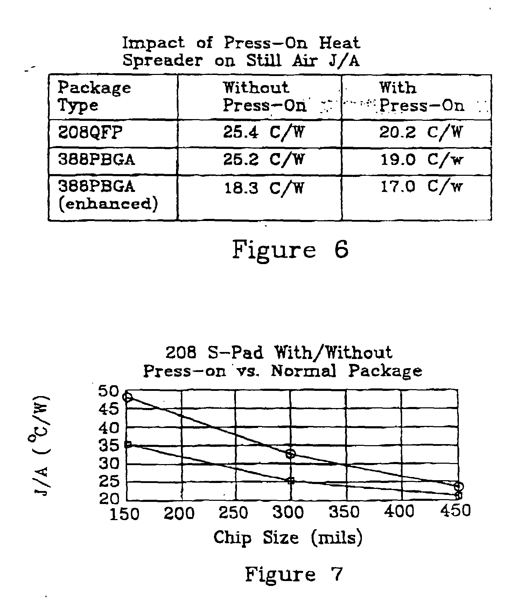

Figure 5 shows another embodiment 30 of a stamped/fin heat sink. Heat sink plate 31 has a plurality of fins 33 stamped along two edges. A third edge 34 is not cut and is attached to heat sink plate 31. Each fin 33 is bent upward along edge 33 to raise fins 33 out of the plane of heat sink plate 31 to provide better heat dissipation. An adhesive 32 is on one side of plate 31 to permit adherence to a semiconductor package. Each fin 33 may have a high thermal emissivity surface finish 33a. This coating may be deposited, painted or otherwise placed on the heat sink surface.

Other punched fin configurations are possible and within the scope and spirit of this invention.

Figure 6 is a table showing improvement in heat dissipation with the use of a press-on heat sink of the present invention. Three different semiconductor package were tested. With a 208 pin quad flat package(PQFP), the operating temperature of the device was modeled by aid of a computer with and without a press on heat sink, but no heat spreader (not punched-out fins). Without a heat spreader, J/A (Air junction to ambient thermal resistance) was 25.4 Degree C. per watt (C/W). With a press on heat spreader, the J/A was 20.2 C/W. This is an improvement of 5.2 C/W. Similarly, a 388 Pin Ball Grid Array (PBGA) semiconductor device with a press on heat spreader showed an improvement of 6.2 C/W, and a 388 PBGA thermally enhanced device showed an improvement of 1.3 C/W.

Figure 7 shows the improvement for a 208 S-Pad device over a range of semiconductor chip sizes. The smaller the chip size, the better the improvement. For a 150 mils chip the J/A was reduced from about 49 to 35. For a 300 mils chip, the J/A was reduced from about 33 to 26.

The above results shows that a low cost stamped attachable heat sink can provide thermal dissipation benefits. Thinner and less expensive packages can be used resulting from the reduced package cost of not having to use a heat spreader molded in the package to improve the package thermal performance.

## Claims

1. A heat sink and heat spreader arrangement for mounting on a semiconductor device, comprising:
a heat sink plate having first and second surfaces, said first surface serving as a thermal dissipation surface; and
an adhesive applied to the second surface of said heat sink plate for adhering the heat sink to the surface of a semiconductor device.

2. The arrangement according to Claim 1, wherein said first surface has at least one heat dissipation fin having a plurality of edges formed therefrom and attached to said first surface along one of said plurality of edges of said heat dissipation fin.

3. The arrangement according to Claim 1 or Claim 2 further comprising: edges around said heat sink plate, said edges extending downward from a plane of the heat sink plate.

4. The arrangement according to any preceding claim further comprising; at least one heat dissipation fin integral with the heat sink plate.

5. The arrangement according to any preceding claim, wherein the thermal dissipation surface of the heat sink plate has a high thermal emissivity coating thereon.

6. The arrangement according to Claim 5, wherein the high thermal emissivity coating is black.
